(19) Europäisches Patentamt
European Patent Office
Office européen des brevets

(11) **EP 4 546 579 A1**

(12) **EUROPEAN PATENT APPLICATION**

(43) Date of publication:
**30.04.2025 Bulletin 2025/18**

(51) International Patent Classification (IPC):
**H01S 5/14** $^{(2006.01)}$   **H01S 5/06** $^{(2006.01)}$
**H01S 5/12** $^{(2021.01)}$

(21) Application number: **23205551.7**

(22) Date of filing: **24.10.2023**

(52) Cooperative Patent Classification (CPC):
**H01S 5/141;** H01S 5/0612; H01S 5/1237;
H01S 5/124; H01S 5/142

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nederlandse Organisatie voor
toegepast-natuurwetenschappelijk Onderzoek
TNO
2595 DA 's-Gravenhage (NL)**

(72) Inventor: **ABDOU, Aly Refaey Aly
2595 DA 's-Gravenhage (NL)**

(74) Representative: **V.O.
P.O. Box 87930
2508 DH Den Haag (NL)**

(54) **EXTERNAL CAVITY LASER**

(57)    An improved external cavity laser (1) is provided herein that comprises a gain section (2) and an external cavity passive chip (3) with a first end (31) that is optically coupled to the gain section (2) and with a second end (35) providing a laser output, the external cavity passive chip (3) having a cavity (33) between the first end (31) and a phase shifted Bragg grating, FBG (34).

FIG 2

EP 4 546 579 A1

**Description**

BACKGROUND

The present invention pertains to an external cavity laser. An external cavity laser comprises a gain section, which is a source of incoherent light and an external cavity that receives the incoherent light and outputs a coherent laser beam.

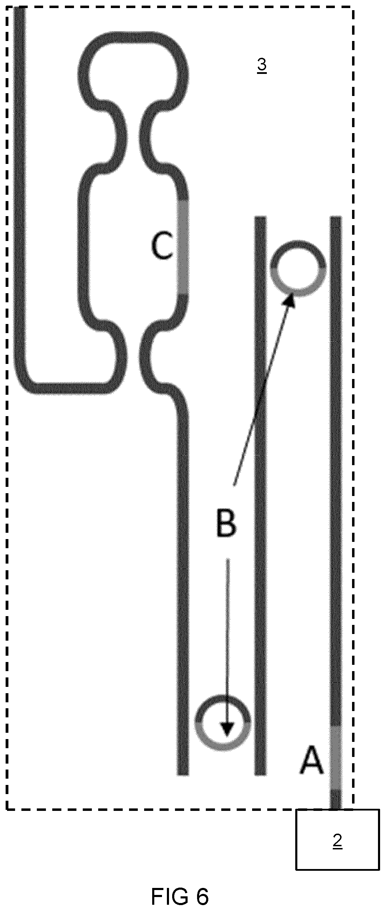

A known external cavity laser is described by Guo in "Hybrid external cavity laser with a 160-nm tuning range" in a conference paper for Conference on Lasers and Electro-Optics 2020. As shown schematically in FIG. 6, the device as disclosed therein comprises an InP reflective semiconductor optical amplifier (RSOA) 2 that is butt-coupled to a SiN chip 3. The SiN chip comprises amongst others a thermo-optic (TO) phase shifter A, a two-ring based Vernier filter B, and a tunable Sagnac loop reflector C. The Sagnac loop reflector C provides feedback to the laser cavity and the two-ring based Vernier wavelength (frequency) filter B serves to select the laser output wavelength. The known external cavity laser requires a relatively large area.

There is a need to provide a more compact external cavity laser.

SUMMARY

In accordance with the present invention an improved external cavity laser is provided.

The improved external cavity laser comprises a gain section and an external cavity passive chip with a first end that is optically coupled to the gain section and with a second end providing a laser output. The external cavity passive chip has a cavity between the first end and a phase shifted Bragg grating, FBG. The phase shifted Bragg grating also denoted as FBG is provided with a discontinuity that causes a phase shift between the forward and backward travelling waves. Whereas the unmodified Bragg grating is a notch transmission filter, the FBG provides for a narrow transmission peak within the blocked transmission band. In the improved external cavity laser the phase shifted Bragg grating, FBG, serves both as a reflector for providing optical feedback to the cavity as well as a filter to transmit laser radiation with a narrow linewidth. This enables a compact implementation.

In an embodiment the discontinuity is a n-phase discontinuity. Therewith it is achieved that the FBG has a single transmission peak within the reflection band. Nevertheless other embodiments are conceivable, wherein the FBG has a longer discontinuity. In that case, the FBG has more than one transmission peak within the reflection band.

In some embodiments the wavelength of the transmission peak is controllable. As compared to the conventional arrangement as shown in FIG. 6 wavelength control is simplified. The wavelength around which the transmission peak is centered can be tuned by controlling the discontinuity formed in the FBG. Hence controlling operation of the improved device is simplified in comparison to that of the conventional device which requires both tuning of the Sagnac loop and tuning the Vernier rings. For optimal efficiency, the optical length of the cavity can be controlled with a cavity length control element at a first end where the cavity is optically coupled to the gain section. For this purpose heating elements, for example resistive heating elements may be provided. The heat generated near the discontinuity causes the length thereof to change. Therewith the wavelength for which a predetermined phase-shift (e.g. a phase shift $\pi$) is achieved between the forward and backward travelling waves can be tuned by appropriately heating the discontinuity. Likewise the cavity length control element near the first end may be a (resistive) heating element with which the length of the cavity is controlled at a value that is an integer multiple of the desired wavelength. This approach is applicable to virtually all materials suitable for implementation of the passive optical chip, including materials that are generally applied in the semiconductor industry, such as silicon and compounds thereof, like silicon oxide, silicon nitride, silicon oxynitride, silicon carbide, silicon phosphide and other materials like calcium fluoride, magnesium oxide, magnesium fluoride. Nevertheless also other approaches are applicable, for example using electro-optically active materials. Some examples of such materials are lithium niobate (LiNbO3), lithium tantalate (LiTaO3), potassium titanyl phosphate (KTP) and $\beta$-barium borate (BBO). In that case the optical length of the discontinuity or of the cavity can be controlled by an electric field. In still further examples the optical length is controlled by mechanical stress. Also combinations are possible wherein a first approach is used to control the optical length of the discontinuity and a second approach differing from the first approach is used to control the optical length of the cavity.

Surprisingly, it has been found that a more efficient operation is achieved when the discontinuity, for example with phase shift $\pi$ is located closer to a first end of the FBG facing the cavity than to a second end of the FBG facing the laser output. In that case the sum of reflected radiation power and transmitted radiation power is higher than can be achieved when the $\pi$-phase discontinuity is in the center, or is closer to the second end.

In exemplary embodiments thereof, a $\pi$-phase discontinuity is located at a position that is at a distance D from the first end of the FBG that is selected in the range of 15 to 45% of a length L of the FBG. For example, the distance D is in a range of 30 to 40% of the length L of the FBG.

A very compact arrangement of the external cavity laser is achieved with a meandering waveguide. In an example thereof the external cavity passive chip has a photonic waveguide that in a direction from the first end to the second end subsequently comprises a first linear section, a first U-turn section, a second linear section, a second U-turn section, and third linear section.

In an embodiment the FBG is a sidewall-modulated FBG. Alternatively it is possible to provide the FBG as a sequence of longitudinal sections alternating in refractive index. One method, for example, is by injecting ions in the structure to change the refractive index. Alternatively changes in refractive index can be achieved by laser radiation. However, it is preferred to provide the FBG as a side-wall modulated FBG having longitudinal sections with alternating cross-section. In this way a smaller footprint can be achieved.

BRIEF DESCRIPTION OF THE DRAWINGS

These and other details are described in more detail with reference to the drawings. Therein:

FIG. 1 schematically shows a first embodiment of an improved external cavity laser as disclosed herein;
FIG. 2 schematically shows another embodiment of the improved external cavity laser;
FIG. 3 schematically shows spectral characteristics of various embodiments of the improved external cavity laser;
FIG. 4 shows a component of another embodiment of the improved external cavity laser;
FIG. 4A shows a detail of the component of FIG. 4;
FIG. 4B shows a detail of a variation of the component of FIG. 4;
FIG. 5 schematically shows a still further embodiment of the improved external cavity laser;
FIG. 6 schematically shows an external cavity laser according to the prior art.

DETAILED DESCRIPTION OF EMBODIMENTS

Like reference symbols in the various drawings indicate like elements unless otherwise indicated.

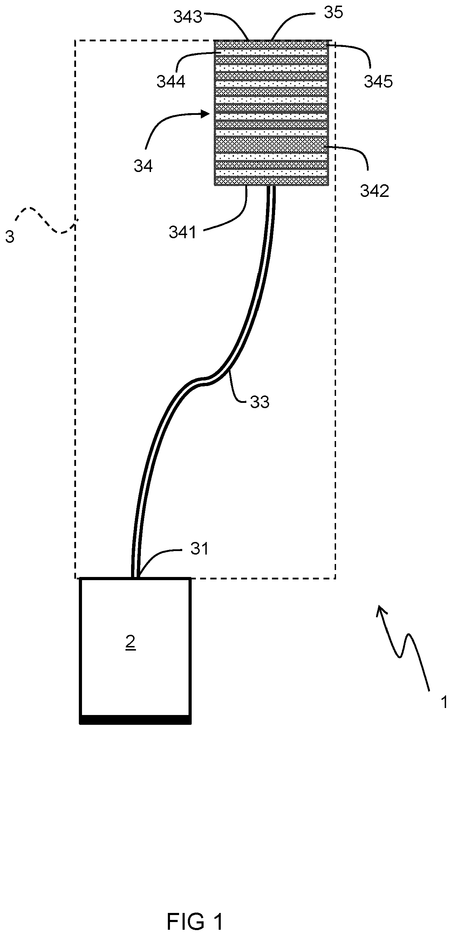

FIG. 1 schematically shows a first embodiment of an improved external cavity laser 1 as disclosed herein. As shown in FIG. 1, the improved external cavity laser 1 comprises a gain section 2 and an external cavity passive chip 3 that is optically coupled with its first end 31 to the gain section 2, while a second end 35 of the external cavity passive chip 3 provides a laser output. The external cavity passive chip 3 comprises a phase shifted Bragg grating, FBG 34, near its second end 35. A cavity 33 is defined between the first end 31 and the FBG 34. In the embodiment shown, the FBG 34 comprises a sequence of longitudinal sections 344, 345 alternating in refractive index. In the example shown the dark hatched sections 345 have an refractive index n1 that is higher than the refractive index n0 of the lighter sections 344. The sections have a thickness d1, d2 such that $d1*n1 = d2*n2 = \lambda/2$, wherein d1, d2 is the thickness of the low index sections and the high index sections respectively and $\lambda$ is a central wavelength of the reflection band of the FBG 34. The FBG 34 has a discontinuity 342, for example a $\pi$-phase discontinuity. In the example shown the discontinuity 342 is located closer to a first end 341 of the FBG 34 facing the cavity 33 than to a second end 343 of the FBG 34 facing the laser output. By way of example, the cavity 33 is made of silicon nitride and the materials of the low index sections 344 and the high index sections 345 are silicon dioxide and silicon nitride respectively. The discontinuity 342 in the FBG 34 provides for a transmission peak within the reflection band of the FBG as discussed in more detail below. The gain section 2 is for example a reflective semiconductor optical amplifier. Dependent on a desired wavelength range, suitable semiconductor materials for this purpose include gallium arsenide (GaAs), indium phosphide (InP), and gallium nitride (GaN).

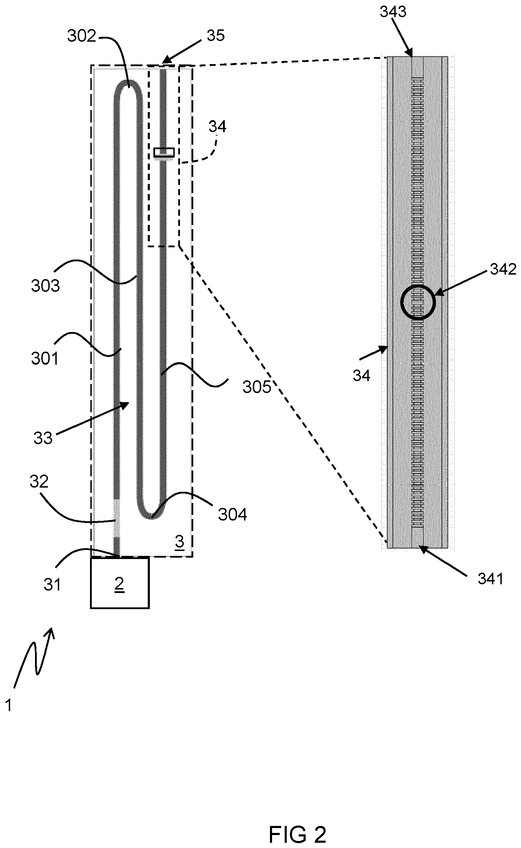

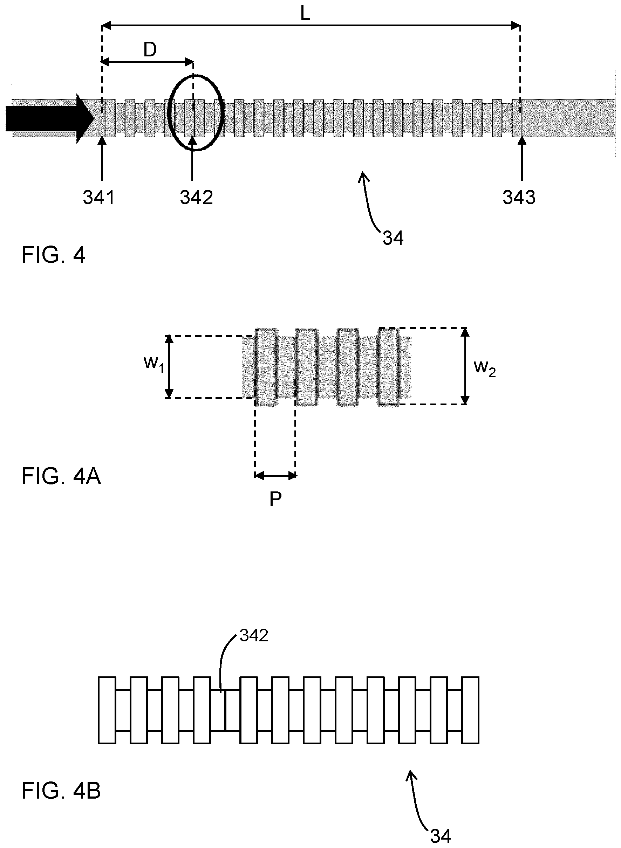

FIG. 2 schematically shows another embodiment of the improved external cavity laser 1. As in the embodiment of FIG. 1 the improved external cavity laser 1 comprises a gain section 2 and an external cavity passive chip 3 that is optically coupled with its first end 31 to the gain section 2, while a second end 35 of the external cavity passive chip 3 provides a laser output. Also, the external cavity passive chip 3 comprises a phase shifted Bragg grating, FBG 34 near its second end. The FBG 34 in this embodiment is shown in more detail in the right hand part of FIG. 2, the FBG 34 is provided with a discontinuity 342, in this case a $\pi$-phase discontinuity. As can be seen therein, and as more explicitly shown in FIG. 4, the FBG 34 in this embodiment is a sidewall-modulated FBG. That is, the FBG has longitudinal sections with alternating cross-section. In an example, illustrated in FIG. 4A, the cross-sectional diameter alternates between $wi = 600$ nm and $w_2 = 1000$ nm, and the FBG has a period P of 425 nm. The discontinuity 342, in this case a $\pi$-phase discontinuity is provided as an elongated section having a length equal to the period P and a diameter of 1000 nm. Alternatively the discontinuity may have the smaller diameter of 600 nm. The side-wall modulated FBG 34 as shown in the embodiment of FIG. 2 renders it possible to achieve a smaller footprint than is the case with a refractive index modulated FBG as presented in FIG. 1. FIG. 4B shows that the discontinuity can alternatively be provided as an elongated section with the smaller diameter wi. It is also possible to have a discontinuity with a length exceeding the Bragg period P. Therewith the location of the transmission peak moves away from the middle of the reflection valley. Therewith the lasing wavelength can be chosen different from the mid-wavelength of the reflector. However, by further increasing the length of the segment, the free spectral range decreases, as a result of which an increasing number of transmission peaks within the reflection valley is obtained instead of the single transmission peak. It is preferred to design the discontinuity such that the FBG has a single transmission peak within the reflection valley so that additional filtering to remove undesired transmission peaks is not necessary.

In the embodiment shown in FIG. 2, the external cavity laser is provided in a compact arrangement with a meandering photonic waveguide 33. More specifically in this example in a direction from the first end 31 to the second end 35 the photonic waveguide 33 subsequently comprises a first linear section 301, a first U-turn section 302, a second linear section 303, a second U-turn section 304, and third linear section 305. In other examples, depending on application requirements, the photonic waveguide 33 is applied as a single linear element or composed of a larger number of linear sections coupled by curved sections. In an embodiment the external cavity passive chip 3 has dimensions of 400 $\mu$m $\times$ 2 $\mu$m.

In the example, shown in FIG. 2, the $\pi$-phase discontinuity 342 is provided at a central position between both ends 341 and 343 of the FBG 34.

In a more general case, optical properties of the FBG can be modeled with the following equation:

$$\begin{bmatrix} a_0 \\ b_0 \end{bmatrix} = \begin{bmatrix} A & B \\ C & D \end{bmatrix}^{N1} \begin{bmatrix} e^{i.k.P/2} & 0 \\ 0 & e^{-i.k.P/2} \end{bmatrix} \begin{bmatrix} A & B \\ C & D \end{bmatrix}^{N2} \begin{bmatrix} a_{N1+N2} \\ 0 \end{bmatrix} \quad (1)$$

Therein $a_0$ is the incident light on end 341 of the FBG 34, $b_0$ is the reflected light at the end 341, and $a_{N1+N2}$ is the transmitted light at end 343 of the FBG 34.

On the right hand side of the equation, the first ABCD matrix describes the first part of the Bragg reflector between the first end 341 and the discontinuity 342, the middle matrix describes the discontinuity 342, and the last ABCD matrix describes the second part of the Bragg reflector between the discontinuity 342 and the second end 343. The exponent of e (*i.k. P*/2) is the phase shift imposed by the discontinuity 342. A, B, C, and D are the transfer matrix elements that translate the incident electromagnetic field from the input side to the output side and are described by the following equations, assuming TE polarization:

$$A = e^{ik_1 P/2}\left[\cos\left(k_2 . \frac{P}{2}\right) + \frac{i}{2}\left(\frac{k_2}{k_1} + \frac{k_1}{k_2}\right)\sin\left(k_2 . \frac{P}{2}\right)\right]$$

$$B = e^{-ik_1 P/2}\left[\frac{i}{2}\left(\frac{k_2}{k_1} - \frac{k_1}{k_2}\right)\sin\left(k_2 . \frac{P}{2}\right)\right]$$

$$C = e^{ik_1 P/2}\left[-\frac{i}{2}\left(\frac{k_2}{k_1} - \frac{k_1}{k_2}\right)\sin\left(k_2 . \frac{P}{2}\right)\right]$$

$$D = e^{-ik_1 P/2}\left[\cos\left(k_2 . \frac{P}{2}\right) - \frac{i}{2}\left(\frac{k_2}{k_1} + \frac{k_1}{k_2}\right)\sin\left(k_2 . \frac{P}{2}\right)\right]$$

Therein k, k1 and k2 are the wavevectors determined by the properties of the segments of the FBG. In an example k1 is the wavevector inside the segments having the diameter $w_2$ (See FIG. 4A), k2 is the wavevector inside the segments having diameter wi, and k is the wavevector in the discontinuity. k can be equal to either k1 or k2 depending on whether the discontinuity is wide or narrow.

Also, the value of k in the exponent ($\pm$ik.P/2), can be adapted to tune the resonant wavelength so as to determine the output wavelength of the laser.

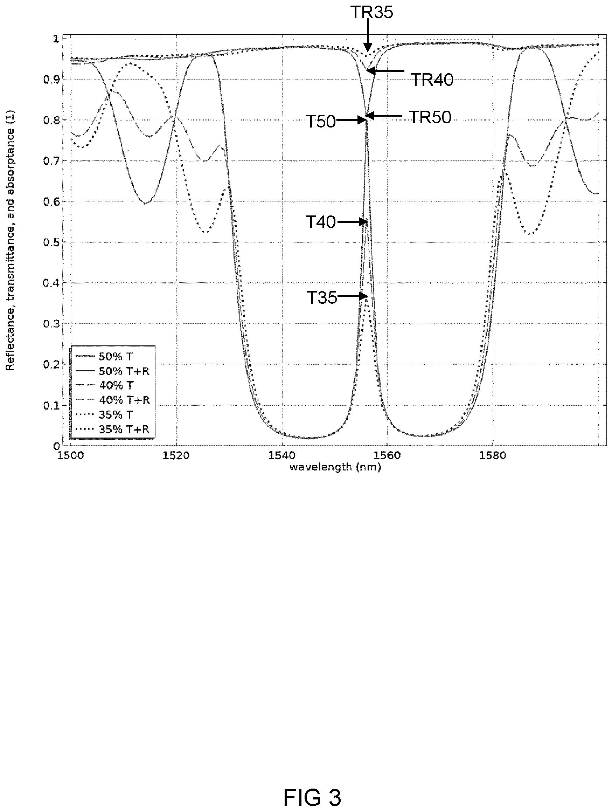

FIG. 3 schematically shows exemplary spectral characteristics for embodiments of the FBG. For the example when the first part and the second part of the FBG are of equal length, the transmission characteristics are indicated by T50. The efficiency characteristics are indicated by TR50, this is the sum of transmission and reflection. It can be seen in FIG. 3 that FBG 34 has a relatively high reflectivity in the ranges of 1540-1550 nm and 1560 to 1570 nm. Between these ranges the FBG 34 has a relatively narrow transmission peak centered around 1555 nm. In this embodiment the transmission T50 in the transmission peak is about 80%. The sum of transmission and reflection TR50 in the transmission peak is also about 80%. Accordingly about 20% of the incoming radiation having the wavelength of the transmission peak is lost.

In other embodiments, as shown in FIG. 1 and FIG. 4, the discontinuity 342 is located closer to the first end 341 of the FBG 34, i.e. the end of the FBG 34 facing the cavity 33, than to the second end 343 that faces the laser output. FIG. 4 illustrates the location of the discontinuity 342 at a distance D from the first end 341 in the FBG having a length L.

As shown in FIG. 3, reducing the ratio D/L to a value lower than 0.5 reduces the height of the transmission peak but improves the efficiency of the FBG 34, i.e. reduces the amount of radiation that is absorbed. By way of example T40 indicates the transmission of an FBG wherein the $\pi$-phase discontinuity 342 is located at a position that is at a distance D from the first end 341 of the FBG 34, equal to 40% of the length L of the FBG. It can be seen that the transmission is still relatively high, about 55%, but that the losses are reduced. I.e. about 92% of the radiation at wavelength 1555 is either reflected or transmitted. Hence only 8% is lost.

In a still further embodiment the $\pi$-phase discontinuity 342 is located at a position that is at a distance D from the first end 341 of the FBG 34, equal to 35% of the length L of the FBG. It can be seen that the transmission T30 is now reduced to about 35%, but that the losses are further reduced. I.e. about 95% of the radiation at wavelength 1555 is either reflected or transmitted. Hence only a few percent is lost.

It can further be shown that when positioning the discontinuity closer to the cavity, the reduction in output efficiency is less than the reduction in transmission, because a substantial part of the radiation that is not outputted directly is outputted after one or more reflections inside the cavity.

Moreover, by increasing the reflectivity r of the FBG, also the coherence length of the outputted radiation is improved.

Some other exemplary embodiments (EMB 1-6) are shown in the following table. Therein N1, N2 respectively are the number of Bragg periods of the FBG 34 at the side of the cavity and away from the cavity. N is the sum of N1 and N2. L is the length of the FBG 34, wherein it is presumed that the tooth pitch P of the FBG is 425 nm. The last column indicates the ratio D/L. By way of example, the designs are being fabricated in 800nm thick silicon nitride and the width of the designs is 1 micron, and the etched tooth depth is 200nm on each side (in the direction perpendicular to light propagation).

| EMB | N1 | N2 | N | L($\mu$m) | D/L |
| --- | --- | --- | --- | --- | --- |
| 1 | 15 | 35 | 50 | 21.25 | 0.3 |
| 2 | 20 | 30 | 50 | 21.25 | 0.4 |
| 3 | 30 | 70 | 100 | 42.5 | 0.3 |
| 4 | 40 | 60 | 100 | 42.5 | 0.4 |
| 5 | 60 | 140 | 200 | 85 | 0.3 |
| 6 | 80 | 120 | 200 | 85 | 0.4 |

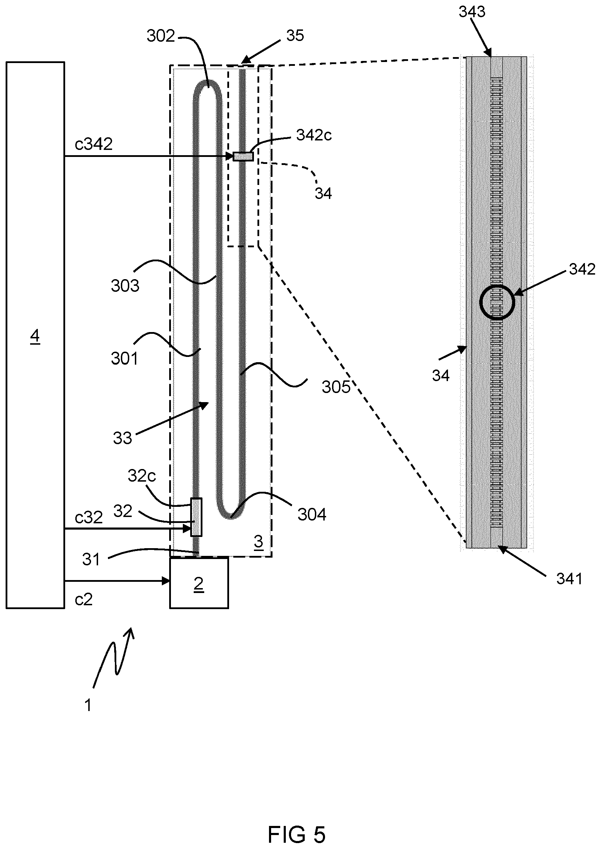

As illustrated with reference to FIG. 5, a wavelength of the transmission peak can be tuned more easily than is possible in the conventional arrangement. This conventional arrangement requires that the Sagnac loop, the pair of Vernier rings and the cavity length tuner are controlled in a coordinated manner in order to control the wavelength of the transmission peak.

In an embodiment of the improved external cavity laser as shown in FIG. 5, the peak transmission wavelength can be more easily controlled with a pair of control signals c342, c32, one to control the FBG-discontinuity 342 and one to control the length tuner 32. To that end the external cavity laser 1 includes a controller 4 that provides a control signal c342 for controlling a resistive heating element 342c near the discontinuity 342. The controller 4 further provides a control signal c32 for controlling a resistive heating element 32c of the cavity length control element 32. In an embodiment a lookup table is prepared with predetermined settings for the resistive heating element 342c for obtaining a desired peak transmission wavelength. These settings are for example a setting of the appropriate temperature of the resistive heating element to be achieved or a setting of an electrical power with which the appropriate temperature is achieved. Subsequently the lookup table can be used to control the resistive heating element temperature to achieve a desired transmission peak wavelength. Alternatively the relationship between the electric power and the transmission peak wavelength or the relationship between the resistive heating element temperature and the transmission peak wavelength can be modeled as a polynomial function. Therewith the transmission peak wavelength can be controlled in a feedforward manner using the lookup table or the polynomial function. In another embodiment a feedback control loop is used to control the transmission peak wavelength, by measuring the actual transmission peak wavelength, determining a difference with the desired transmission peak wavelength and tuning the power supplied to the resistive heating element to minimize this difference. In a still further embodiment, these approaches are combined, in that a feedforward controller provides a control signal indicative for a supply power expected to be suitable for achieving the desired transmission peak wavelength, and a feedback controller that provides a tuning signal to minimize a remaining difference between the measured wavelength and the desired wavelength. Likewise the resistive heating element 32c can be controlled according to one of these approaches to tune the length of the laser cavity so as to match the desired wavelength.

As noted above, other mechanisms are possible to control the transmission peak wavelength and the length of the cavity, such as mechanical strain and an electric field. The same approaches, feedforward, feedback or a combination thereof can be used for using these mechanisms to achieve a desired transmission peak wavelength and cavity length.

Therewith the wavelength of a transmission peak of the FBG, i.e. the wavelength outputted by the laser can be maintained at a predetermined value in case it tends to drift due to external circumstances, or can be varied so as to match requirements of an application.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. An external cavity laser (1) comprising a gain section (2) and an external cavity passive chip (3) with a first end (31) that is optically coupled to the gain section (2) and with a second end (35) providing a laser output, the external cavity passive chip (3) having a cavity (33) between the first end (31) and a phase shifted Bragg grating, FBG (34).

2. The external cavity laser (1) according to claim 1, wherein the FBG (34) is provided with a $\pi$-phase discontinuity (342).

3. The external cavity laser (1) according to claim 1 or 2, wherein discontinuity (342) in the FBG is located closer to a first end (341) of the FBG (34) facing the cavity (33) than to a second end (343) of the FBG (34) facing the laser output.

4. The external cavity laser (1) according to claim 3, wherein the discontinuity (342) is located at a position that is at a distance (D) from the first end (341) of the FBG (34) that is selected in the range of 15 to 45% of a length (L) of the FBG.

5. The external cavity laser (1) according to one of the preceding claims comprising a meandering photonic waveguide (33).

6. The external cavity laser (1) according to claim 5, wherein the photonic waveguide (33) in a direction from the first end (31) to the second end (35) subsequently comprises a first linear section (301), a first U-turn section (302), a second linear section (303), a second U-turn section (304), and third linear section (305).

7. The external cavity laser (1) according to one of the preceding claims, wherein the FBG (34) is a sidewall-modulated FBG.

8. The external cavity laser (1) according to one of the preceding claims, comprising a wavelength tuning element (342c) for tuning a wavelength of a transmission peak of the FBG (34) and a controller (4) for controlling the tuning element.

9. The external cavity laser (1) according to claim 8, wherein the wavelength tuning element (342c) is configured to thermally control the wavelength of the transmission peak.

10. The external cavity laser (1) according to claim 8 or 9, wherein the external cavity passive chip (3) further comprises a length tuning element (32c) at its first end (31) and wherein the controller (4) is configured to jointly control the wavelength tuning element (342c) and the length tuning element (32c) for maintaining a ratio between a cavity length and a wavelength of the transmission peak at an integer value.

FIG 1

FIG 2

FIG 3

FIG. 4

FIG. 4A

FIG. 4B

FIG 5

FIG 6

# EP 4 546 579 A1

**Europäisches Patentamt**
**European Patent Office**
**Office européen des brevets**

## EUROPEAN SEARCH REPORT

**Application Number**

EP 23 20 5551

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 515 157 A (NANJING UNIV SUZHOU HIGH TECH INSTITUTE) 29 November 2019 (2019-11-29) | 1-4,7-10 | INV. H01S5/14 |
| Y | * paragraph [0081]; figure 5 * * paragraphs [0068] - [0075]; figure 2 * ----- | 5,6 | ADD. H01S5/06 H01S5/12 |
| X | US 2016/170141 A1 (LUO YING L [US] ET AL) 16 June 2016 (2016-06-16) | 1,2,5, 7-10 | |
| Y | * paragraphs [0028] - [0036]; figure 3 * ----- | 6 | |
| X | US 2023/133316 A1 (YAN XUEJIN [US]) 4 May 2023 (2023-05-04) | 1,3,4, 7-10 | |
| Y | * paragraphs [0088] - [0095], [0100], [0101], [0105]; figures 1,8 * ----- | 5,6 | |
| Y | US 2023/327403 A1 (SCOFIELD ADAM [US] ET AL) 12 October 2023 (2023-10-12) * paragraphs [0064] - [0072]; figures 1,2 * ----- | 5,6 | |

**TECHNICAL FIELDS SEARCHED (IPC)**

H01S

The present search report has been drawn up for all claims

| Place of search | Date of completion of the search | Examiner |
|---|---|---|
| Munich | 13 March 2024 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    **EP 23 20 5551**

This annex lists the patent family members relating to the patent documents cited in the above-mentioned European search report.
The members are as contained in the European Patent Office EDP file on
The European Patent Office is in no way liable for these particulars which are merely given for the purpose of information.

13-03-2024

| Patent document cited in search report | | Publication date | Patent family member(s) | | Publication date |
|---|---|---|---|---|---|
| CN 110515157 | A | 29-11-2019 | NONE | | |
| US 2016170141 | A1 | 16-06-2016 | NONE | | |
| US 2023133316 | A1 | 04-05-2023 | GB | 2612376 A | 03-05-2023 |
| | | | US | 2023133316 A1 | 04-05-2023 |
| | | | WO | 2023078931 A2 | 11-05-2023 |
| US 2023327403 | A1 | 12-10-2023 | CN | 116896002 A | 17-10-2023 |
| | | | US | 2023327403 A1 | 12-10-2023 |

EPO FORM P0459

For more details about this annex : see Official Journal of the European Patent Office, No. 12/82